# EUROPEAN PATENT SPECIFICATION

(11) **EP 1 088 444 B1**
(45) Date of publication and mention of the grant of the patent: **28.08.2002**
(21) Application number: 99928672.7
(22) Date of filing: 15.06.1999
(51) Int. Cl.: H04N 3/00

(54) **REDUCING STRIPED NOISE IN CMOS IMAGE SENSORS**
REDUZIERUNG VON STREIFENFÖRMIGEN STÖRUNGEN IN CMOS BILDSENSOREN
DIMINUTION DU BRUIT SEGMENTE DANS DES DETECTEURS D'IMAGE CMOS

(30) Priority: 17.06.1998 US 99111
(43) Date of publication of application: 04.04.2001
(60) Divisional application: 01111599.5
(73) Proprietor: Foveon, Inc., Santa Clara, CA 95051 (US)
(72) Inventor: MERRILL, Richard, B., Woodside, CA 94062 (US); MEAD, Carver, A., Santa Clara, CA 95051-0951 (US); LYON, Richard, F., Los Altos, CA 94022 (US); TURNER, Richard, M., Mountain View, CA 94041 (US)
(74) Representative: von Hellfeld, Axel, Dr. Dipl.-Phys.,
(86) International application number: US9913471
(87) International publication number: WO99066709

(56) References cited:
- EP-A- 0 665 685
- EP-A- 0 725 535

## Description

### BACKGROUND OF THE INVENTION

### 1.Field of the Invention

The present invention relates to a pixel sensor array structure disposed on a semiconductor substrate comprising a plurality of pixel sensor arranged in an array, a column line for each column in said array, each said column line coupled to the pixel sensors associated with that column, a plurality of load devices, each said load device having a first terminal coupled to a corresponding one of said column lines, a plurality of column select switches, each said column select switches having a first terminal and a second terminal, said first terminal of said column select switch coupled to a corresponding one of said column lines, and a common line, said common line coupled to the second terminal of each of said column select switches an to a buffer amplifier.

### 2. The Prior Art

Integrated image sensors are known in the art. New advances in image sensor technologies have allowed these sensors to be fabricated from complementary metaloxide semiconductor (CMOS) technology.

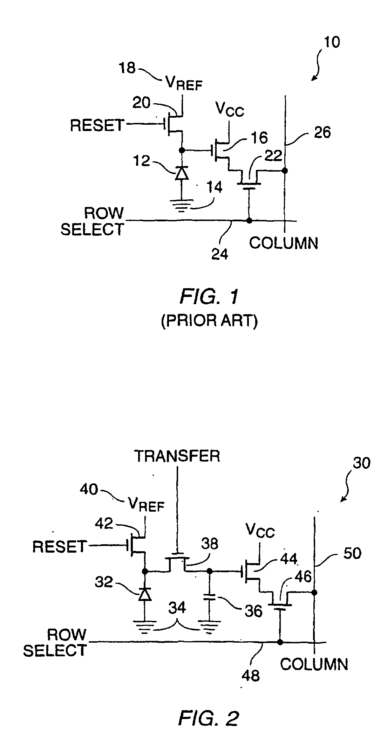

CMOS image sensors and image sensor circuitry may be organized in a manner similar to that which is disclosed in co-pending and not so far published application serial No. 08/969,383, filed November 13, 1997. Individual pixel sensors may be designed in a number of different ways. One possible pixel sensor design is depicted in FIG. 1. Pixel sensor 10 comprises a photodiode 12 having its anode connected to a fixed voltage potential 14 (shown in FIG. 1 as ground). The cathode of photodiode 12 is connectable to an amplifier 16. The cathode of photodiode 12 is also connectable to a reference potential Vref 18 via a reset switch 20 so that the photodiode 12 is reverse biased. The output of the amplifier 16 is attached to a row-select switch 22, which is connected to a row select line 24 and a column line 26.

The pixel sensor depicted in FIG. 1 is operated as follows. First, the pixel sensor 10 is reset by turning on the reset switch 20. Then the reset switch 20 is turned off so that integration of photocurrent from photodiode 12 can begin. The current from the photodiode 12 is integrated on the amplifier 16 input node capacitance to form a voltage signal. At the appropriate time, the voltage on the row select line is raised, which activates the row-select switches 22 in each pixel sensor 10 in the row. This allows the amplifier 16 to drive column line 26. Column line 26 then leads down to more circuitry that will typically amplify and store the signal, and then convert the signal into digital form for inclusion in a digital pixel stream.

Another possible pixel sensor design is depicted in FIG. 2. This pixel sensor design provides for storage of the signal within the pixel sensor and is thus referred to as a storage pixel sensor 30, while the pixel sensor in FIG. 1 is referred to as a non-storage pixel sensor. Storage pixel sensor 30 comprises a photodiode 32 having its anode connected to a fixed voltage potential 34 (shown in FIG. 2 as ground). The cathode of photodiode 32 is connectable to a storage capacitor 36 via a transfer switch 38. Storage capacitor 36 has a first plate connected to transfer switch 38 and a second plate connected to a fixed potential (shown as ground 34 in FIG. 2). The cathode of photodiode 32 is also connectable to a reference potential Vref 40 via a reset switch 42 so that the photodiode 32 is reverse biased. An amplifier 44 has its input connected to storage capacitor 36. The output of the amplifier 44 is attached to a row-select switch 46, which is connected to a row select line 48 and a column line 50.

The pixel sensor depicted in FIG. 2 is operated as follows. First, the pixel sensor 30 is reset by turning on both reset switch 42 and transfer switch 38. Then the reset switch 42 is turned off so that integration of photocurrent from photodiode 32 can begin. Since transfer switch 38 is turned on, the capacitance of the storage capacitor 36 adds to the capacitance of the photodiode 32 during integration, thereby increasing the charge capacity and therefore intensity range of the storage-pixel sensor. This also reduces variation in the pixel output due to capacitance fluctuations since gate oxide capacitance from which storage capacitor 36 is formed is better controlled than junction capacitance of the photodiode 32.

When the integration is complete (determined by exposure control circuitry, not shown), the transfer switch is turned off, isolating the voltage level corresponding to the integrated photocharge on the storage capacitor 36. Shortly thereafter, the photodiode 32 itself is reset to the reference voltage 40 by again turning on reset switch 42. This action will prevent the photodiode 32 from continuing to integrate during the readout process and possibly overflowing excess charge into the substrate which could affect the integrity of the signal on the storage element.

After the reset switch 42 is turned back on, the readout process can begin. At the appropriate time, voltage on the row select line is raised, which activates the row-select switches 46 in each pixel sensor 30 in the row. This allows the current from the amplifier 44 to travel to column line 50. Column line 50 is coupled to more circuitry that will typically amplify the signal, and then convert the signal into digital form for inclusion in a digital pixel stream.

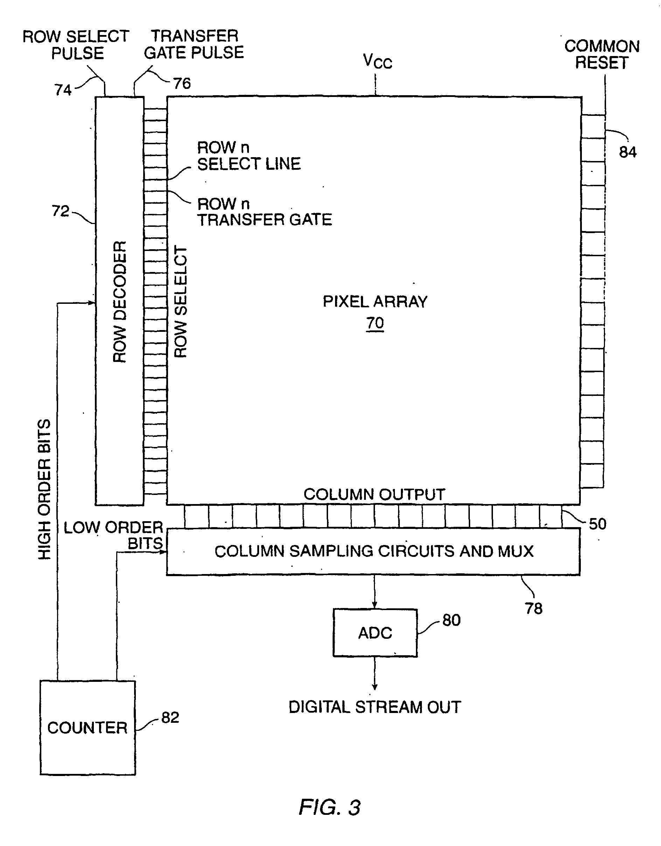

FIG. 3 is a block diagram depicting an example of a pixel sensor array and the surrounding architecture. The pixel sensors are organized in pixel sensor array 70. The row select line of each row of pixel sensors is connected to the row decoder 72. Depending upon the architecture of the pixel sensors, the connection to the row decoder may also be made with a transfer select line. The row decoder 72 receives a row select pulse 74 and activates the row select switches in the appropriate row of pixel sensors. Again, depending upon the architecture of the pixel sensors, the row decoder may or may not receive a transfer gate pulse 76, which activates the transfer switches in the appropriate row of pixel sensors. It is also possible to have an array comprise only a single row of pixel sensors. This is known as a linear imager.

The output of each row of pixel sensors travels down column lines 50 to column sampling and multiplexing circuits 78. This block will amplify each of the column lines and multiplex them, rapidly selecting one at a time, resulting in a stream of amplified signals. This stream will pass through an analog to digital converter 80, such that the output is a stream of digital information. The column sampling circuits and multiplexor block 78 also may store the signals temporarily, for example, to do a subtraction of a noise signal in correlated double sampling architectures. Both the column sampling circuits and multiplexor 78 and the row decoder 72 are controlled by a counter 82.

Additionally, a common reset line 84 is provided which is connected to each pixel sensor's reset switch. Furthermore, in designs using either type of pixel sensor, a correlated double sampling circuit can be added to reduce noise generated by the pixel sensor.

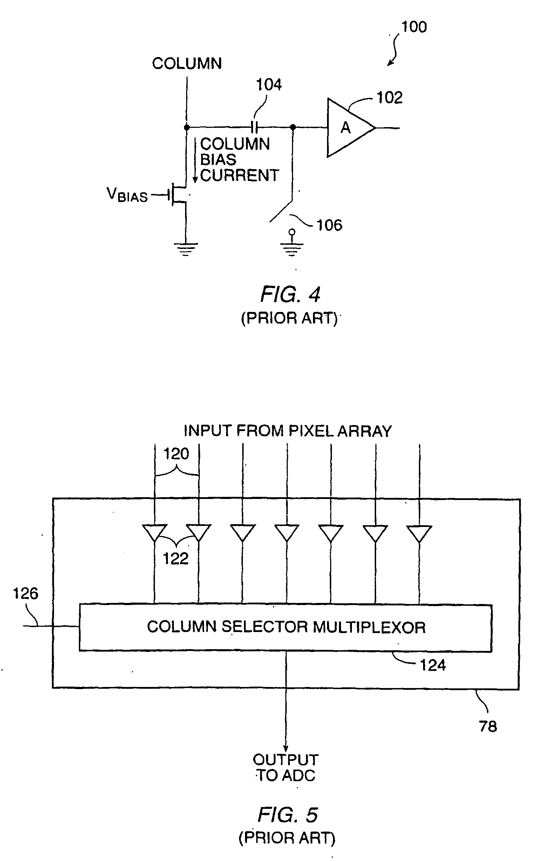

Correlated double sampling can be performed in many different ways, but its function may be generally understood from the following example. FIG. 4 is a circuit diagram depicting an example of a column double sampling circuit 100. One of these circuits may be placed on each column line. The sampling process occurs as follows. First, the signal level for each pixel sensor is read out and stored in the sampling circuitry in the column. Then the transfer switch is turned on again (for that row only) which makes the reference level available to the sampling circuit. This form of double sampling allows for canceling of noise sources in the pixel sensor that are slowly varying compared to the time between the two samples.

With the first signal voltage (V1) present on the left of the capacitor 104, switch 106 is on. The voltage stored across capacitor 104 is equal to the signal voltage V1. Then switch 106 is turned off, and the voltage on the first plate of capacitor 104 moves to a new level (V2) representing the reference voltage. The voltage across capacitor 104 will not change during this time because there is negligible current flowing into the amplifier 102 or through switch 106. Thus both plates of capacitor 104 will change by (V2 - V1), and the voltage at the input of amplifier 102 at the end of the cycle will be (V2 - V1). In this way, noise, offsets, etc can be subtracted from the output of the array. Persons of ordinary skill in the art will recognize that there are other prior art CDS circuits and architectures. A CDS circuit with a CMOS active pixel sensor array was described in Akimoto, et al, United States Patent No. 4,942,474.

FIG. 5 is a block diagram depicting an example of the layout of the column sampling circuits and multiplexor block 78 of FIG. 3. Each column line 120 is coupled to a column amplifier 122, which may include a CDS capability. The column amplifier 122 is then coupled to the multiplexor 124. The multiplexor 124 receives input from an address signal 126, that selects which column should currently be sent to the output. The address signal 126 may be coupled to a counter or other circuit which controls the column address sequence. A signal representative of the voltage on the selected column line 120 is then output, typically to an analog to digital converter.

Fixed pattern noise (FPN) is a visual artifact caused by variation in output pixel values due to device and interconnect mismatches across an image sensor. There are several different kinds of fixed pattern noise, but the most common are random noise and striped noise. Random noise comprises random variations of the individual pixels. Striped noise, on the other hand, comprises random variations from column to column, resulting in vertical bars appearing in the image. The term striped noise really only refers to the stripes occurring in one dimension, since stripes occurring in other dimensions are not usually a problem.

While there are several factors that affect the intensity of fixed pattern noise, the most prominent factor is differences in offsets and gains between amplifiers. Generally, differences in offsets and gains between pixel sensor amplifiers results in random noise, while differences in offsets and gains between column amplifiers results in striped noise. This explains why striped noise is less of a problem in charge-coupled device image sensors (where column amplifiers are not used) than in CMOS image sensors (where column amplifiers generally are used). Random noise can be significantly decreased through the use of correlated double sampling; however, this technique has little or no effect on striped noise.

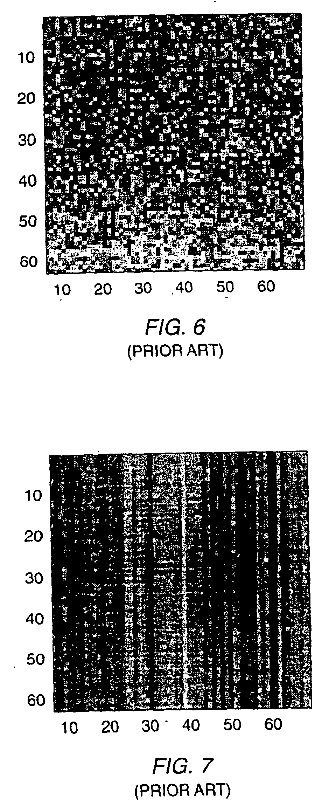

An additional problem arises in CMOS image sensors that use correlated double sampling in that the use of correlated double sampling may be counterproductive. A. El Gamal, B. Fowler, H. Min, and Xinqiao Liu. Modeling and Estimation of FPN Components in CMOS Image Sensors. Proceedings of SPIE, January 1998, Vol. 3301, pp. 168-177, discloses that using CDS, while reducing random noise, does not greatly reduce striped noise, thus resulting in an image where almost all of the noise appears as striped noise. FIG. 6 and FIG. 7 are grayscale images depicted in the El Gamal article which show the somewhat detrimental effect of CDS. FIG. 6 is a grayscale image illustrating the fixed pattern noise generated in a system without CDS. The variance of the striped noise is 451,611 while the variance of the random noise is 7,144,450. This gives a random noise:striped noise variance ratio of 15.8.

FIG. 7 is a grayscale image illustrating the fixed pattern noise generated in a system with CDS. While FIG. 7 contains significantly less random noise, the striped noise is much more noticeable. Random noise is generally less objectionable than striped noise and is useful in masking the intensity of the striped noise. Therefore, the reduction of random noise without a concurrent reduction in striped noise can cause more problems than it solves. The variance of the striped noise is 80,900 and the variance of the random noise is 4,155. This gives a random noise:striped noise variance ratio of 0.05. Thus, the higher the variance ratio the less noticeable the striped noise is. Further investigation has revealed that an architecture in which the fixed pattern noise due to random variations of the pixels is at least 100 times the variance or at least 10 times the root mean square (rms) of the fixed pattern noise due to striped noise is preferred in order to properly mask the striped noise.

A pixel sensor array structure of the at the beginning described type is disclosed in EP 0 665 685 A2. The column reset of this sensor is quite complicated and the load device are quite expensive. It therefore is an object of the invention to suggest a pixel sensor array structure with an easy column reset and an simple load device.

An object of the present invention is to provide an architecture that reduces fixed pattern striped noise in CMOS image sensors.

Another object of the present invention is to provide an architecture that enables fast pixel readout without column amplifiers.

Another object of the present invention is to provide an architecture that works in such a way that the rms fixed pattern noise due to random variations of the pixels is at least 10 times the rms fixed pattern striped noise.

Another object of the present invention is to provide an architecture which allows for the dynamic use of a pixel sensor's source follower amplifier transistor to store charge on the column lines and read out column signals by charge sharing alone in order to aid in accomplishing the other objectives.

Another object of the present invention is to provide an architecture that reduces the effective capacitance of a common output line to speed up settling and lessen blurring of the column signals across a row.

### BRIEF DESCRIPTION OF THE INVENTION

The invention disclosed in claim 1 gives a solution fore the problems discussed before. Details and preferred embodiments are given in the dependent claims 2 to 19.

A pixel sensor array structure which reduces the amount of striped fixed pattern noise includes a plurality of pixel sensors arranged in an array; a column line for each column in the array, each column line coupled to the pixel sensors associated with that columns a plurality of load devices, each load device coupled to one of the column lines and to a column reset reference potential; a plurality of column select switches, each column select switch coupled to one of the column lines; and a common line, the common line coupled to the column select switches and to a buffer amplifier.

A unity-gain buffer amplifier may be coupled to the common line and to a driven shield, which acts to reduce the effective capacitance of the common line. The column select switch transistors may be designed with an annular layout to reduce the capacitance they add to the common line. The load devices may be designed with a relatively large length and width (i.e. large relative to the minimum device size of the technology) to minimize variations in their bias currents. Alternatively, the load devices may be operated as column reset switches.

The pixel values of a specific row may then be read out by discharging all of the column lines in the array to a column reference potential, for example ground, using column reset switches; turning off column reset switches and driving a row-select line high for an appropriate row, which connects source followers to the column lines; waiting a predetermined time for the column lines to be charged; selecting one column line at a time to connect to the common line, thereby sharing the charges between the selected column line and the common line; and buffering the voltages on the common line. A two-tap FIR filter may be coupled to the array amplifier to correct pixel values which may be blurred when fast multiplexing is used. The array structure may be designed such that the rms fixed pattern noise due to random variations in the pixels is at least 10 times the rms fixed pattern striped noise, so that any striped noise that appears will be much less noticeable.

### BRIEF DESCRIPTION OF THE DRAWING FIGURES

FIG. 1 is a circuit diagram depicting an example of a CMOS pixel sensor without storage capability as known in the prior art.

FIG. 2 is a circuit diagram depicting an example of a CMOS pixel sensor with storage capability as known in the prior art.

FIG. 3 is a block diagram depicting an example of an image sensor affray and the surrounding architecture as known in the prior art.

FIG. 4 is a circuit diagram depicting an example of a column double sampling circuit as known in the prior art.

FIG. 5 is a circuit diagram depicting an example of the column sampling circuits and multiplexor block of FIG. 3 as known in the prior art.

FIG. 6 is a grayscale image illustrating the fixed pattern noise generated in a system without CDS.

FIG. 7 is a grayscale image illustrating the fixed pattern noise generated in a system with CDS.

FIG. 8 is a circuit diagram depicting a presently preferred embodiment of the invention.

FIG. 9 is a signal flow diagram depicting the implicit representation of the charge-shared column readout arrangement as first-order linear discrete-time filter.

FIG. 10 is a signal flow diagram depicting a two-tap FIR filter for correcting the blurring in the pixel output.

FIG. 11 is a layout drawing depicting a column select switch having an annular layout.

FIG. 12A is a layout diagram of the top view of a multiple level driven shield.

FIG. 12B is a layout diagram of a side view of a multiple level driven shield taken along section line 12B-12B of FIG. 12A.

### DETAILED DESCRIPTION OF A PREFERRED EMBODIMENT

Those of ordinary skill in the art will realize that the following description of the present invention is illustrative only and not in any way limiting. Other embodiments of the invention will readily suggest themselves to such skilled persons.

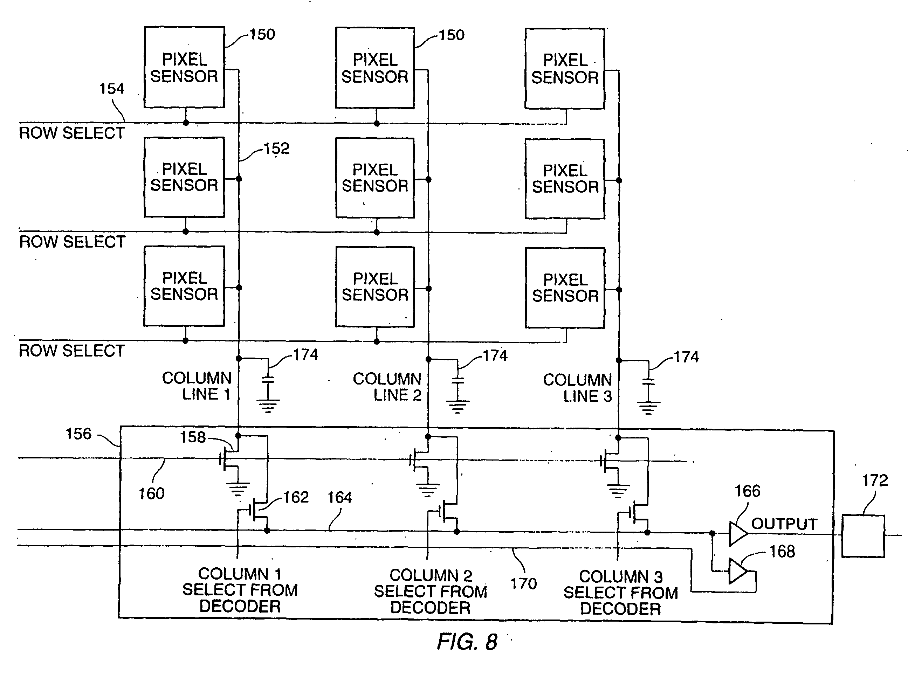

FIG. 8 is a circuit diagram depicting a presently preferred embodiment of the present invention. Pixel sensors 150 are organized in an array as known in the prior art. FIG. 8 depicts an array that has three rows and three columns but the present invention may be used with a pixel sensor array that is of any size. Each pixel sensor may be coupled to a column line 152 and to a row select line 154 as depicted in FIGS. 1-2. The pixel sensors 150 may be of any type and are not limited to the embodiments described in FIG. 1-2. In the multiplexor block 156, the column lines 152 are coupled to load devices 158, which may provide a bias current. The load devices 158 may be fabricated with a relatively large area to reduce random variations in their bias currents. The load devices should have on the order of at least several times the length and width of a minimum sized device of the technology, such as a reset transistor, and may function even better if their gate areas are at least one hundred times the gate area of a minimum sized transistor. Alternatively, the load devices 158 may be coupled to a first potential, such as ground, and to a column reset line 160, which allows the load devices 158 to act as column reset switches.

The column lines 152 are also coupled to column select switches 162. The column select switches 162 may be of any type design, such as MOS transistors. The column select switches are enabled by a decoder and connected to a common line 164 such that when the appropriate signal is received from the decoder, the column select switch 162 is activated and the signal from that column flows onto the common line 164. The common line 164 is coupled to a buffer amplifier 166, which amplifies the signal.

The use of a single buffer amplifier rather than a multiplicity of column amplifiers reduces fixed pattern striped noise because there are no longer variations due to the offset and gain of each column amplifier. One disadvantage of this design is that the settling time constant of the high capacitance common line being driven only by the small amplifier in the pixel sensor is obviously quite slow. Normally, this would make it difficult to get a high pixel signal rate. However, if the multiplexing of the circuit-is performed rapidly, then the voltage on the common line does not settle to an asymptotic value but instead quickly settles to a value determined by charge sharing between the column line and the common line, with a time constant limited by the column select switch rather than by the pixel sensor's amplifier. It is not the same value that would be read out if the circuit were operated at a low multiplexing rate, but it is related by a simple first-order discrete-time function.

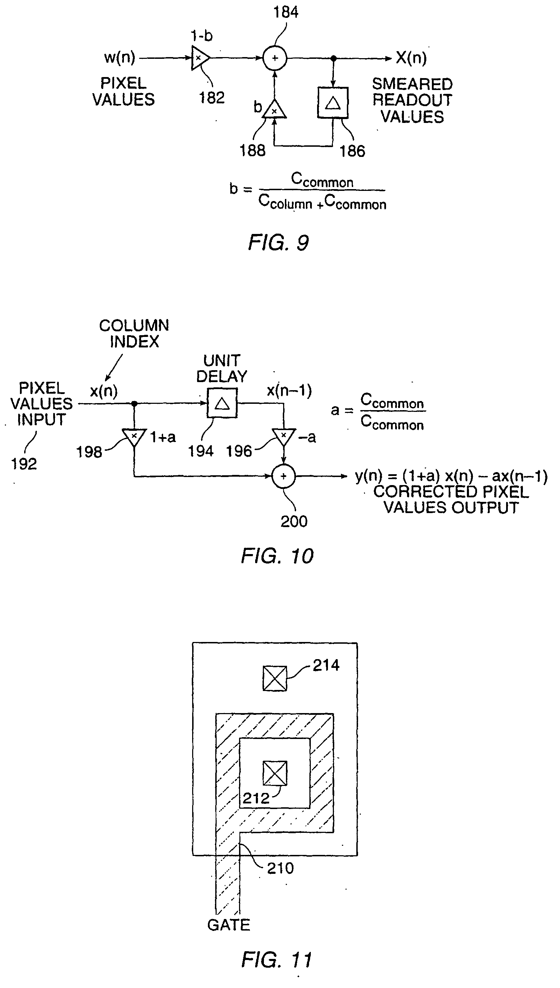

When the column select switch closes, the potentials on the column line and the common line equalize by charge moving as needed from one to the other. The final potential is a linear combination of the two potentials before closing the switch, with weight 1-b for the column line potential and b for the common line potential, where b is the ratio of the common line capacitance to the sum of the common line and column line capacitances. FIG. 9 shows this operation as a signal flow diagram of a first-order recursive discrete-time filter in which the sample delay 186 corresponds to memory of the previous columns signal on the common line, and multipliers 182 and 188 are the weights discussed. If the columns are selected rapidly relative to the time constant associated with the pixel sensor driving the column line, then this filter is a good model of the resulting signals read out through the final amplifier.

The charge-shared column readout arrangement is thus essentially a discrete-time filter which smears the pixel values. Each smeared charge-shared output value x(n) is the weighted sum of the ideal column signal w(n) and the previous output x(n-1), with weight 1-b for the ideal column signal and b for the previous output, where b is the ratio of the common line capacitance to the sum of the common line and column line capacitances.

Referring again to FIG. 8, a two-tap finite-impulse-response (FIR) filter 172 may then be used to correct for the smearing or blurring of the pixel values. Such a filter is illustrated in FIG. 10. Smeared pixel values input 192 is received from the array amplifier and sent to a unit delay 194. The pixel values input 192 is also sent to a multiplier 198. The output from the unit delay 194 is also sent to a multiplier 196. Multiplier 198 then multiplies x(n) by 1+a, where a is the capacitance of the common line divided by the capacitance of the column line. Multiplier 196 then multiplies x(n-1) by -a. Adder 200 adds the outputs of the multipliers 196, 198 together, arriving at a corrected pixel value output (1+a)x(n) - ax(n-1), which is theoretically exactly equal to the original column signal w(n) if the coefficient a is chosen correctly.

Even with the addition of the two-tap FIR filter, there are still some minor disadvantages introduced when using the circuit with the load devices used as bias current sources. The load devices are still a potential cause of striped noise. The bias currents are always flowing in all columns during readouts in order to keep the columns charged to the correct voltage so there is a considerable waste of power. The pixel sensor amplifier, acting as a source follower, responds nonlinearly at the time the column is selected and the voltage on the column line changes, which introduces a slight non-linearity into the resulting discrete-time filter.

In order to remedy these concerns, the whole system may be operated dynamically using linear charge sharing as the only mechanism for getting the signal out. For each row, all column lines are discharged to ground using the load device as a column reset switch. The column reset switch is then turned off and the row select line is activated for a predetermined length of time, connecting the amplifiers in the pixel sensors to the column lines, where they work against the dynamics of charging up the capacitance of the column line rather than against a current source load. The voltages on the column lines increase logarithmically, about 60 mV per common log unit of the length of time they are turned on, rather than on an exponential approach to an asymptote.

After a predetermined time, the column reset switches are turned off. The column lines are charged to voltages in a known predetermined relation to the signals at the inputs of the pixel sensor amplifiers, with random variations that depend on the particular amplifiers but not on the column lines, because the column line capacitances are well matched. One column line at a time is then selected to be connected to the common line, sharing the charges between the selected column line and the common line, and thereby creating a very linear discrete-time filtered version of the sequence of column signals across the row, with little or no dependence on the rate or duration of the column select signals. The design and timing of the column decoder that drives the column select switches must be done with care as known in the art to assure that no glitches occur, because glitches may cause unwanted sharing of charge with columns that are not supposed to be selected.

Another potential problem that may be addressed is the effective capacitance of the common line, which may be so high as to cause the charge sharing to severely blur the column signals across the row. Referring to FIG. 8, this may be addressed by coupling a unity-gain buffer amplifier 168 to the common line 164 in a similar fashion as the array amplifier 166. The output from this unity-gain buffer 168, however, is used as a driven shield line 170 around the common line 164, which will reduce the effective capacitance of the common line 164 and reduce blurring. The driven shield 170 may be placed on multiple levels of metal above, below, and to the sides of the common line 164 to greatly reduce the effective capacitance.

Another optional feature which reduces the effective capacitance of the common line is to design the gate electrode of each column select switch transistor so that it is laid out in an annular fashion around the output terminal to the common line. FIG. 11 is a layout drawing showing a select switch transistor having an annular design. Gate electrode 210 fully surrounds source/drain terminal 212, causing source/drain terminal 212 to have a low capacitance relative to source/drain terminal 214, thus reducing the effective capacitance of the common line to which source/drain terminal 212 is connected.

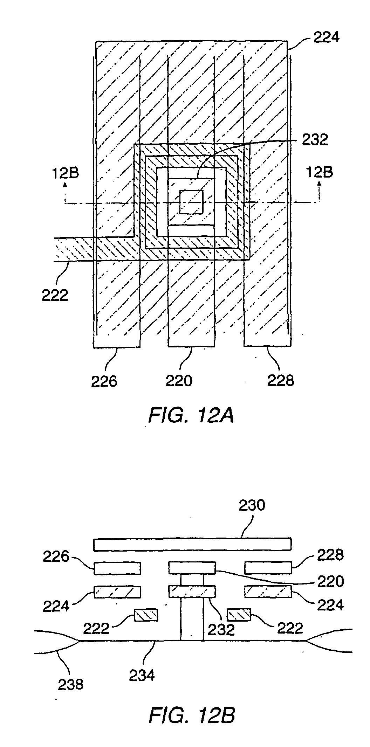

FIG. 12A is a partial layout drawing of a multiple-level driven shield around the common line. FIG. 12B is a corresponding cross section taken at section line 12B-12B in FIG. 12A. Common line 220 on the Metal-2 layer is coupled to each column select switch annular MOS transistor through Metal-1 pad 232 through openings in the insulating oxide layers. The driven shield preferably includes several surrounding portions: an underlying Metal-1 portion 224 with an opening around pad 232; flanking Metal-2 portions 226 and 228; and an overlying Metal-3 portion 230 (shown only in FIG. 12B). The gate 222 of the annular MOS transistor is also shown, as are field oxide areas 236 and thin oxide area 234 associated with the annular MOS transistor.

It is also preferable to design the circuit in such a way as to have the fixed pattern noise due to random variations of the pixels at least 100 times the variance (10 times the root mean square) of the fixed pattern striped noise so that the random texture of the image will mask any residual striped pattern. Prior art systems with CDS typically have a larger striped than random error.

Referring back to FIG. 8, it may also be helpful to add a capacitor 174 tied to each column line 152. This capacitor may then be referenced to a fixed voltage potential, for example ground. This would further reduce blurring and would be especially helpful when the pixel sensor array has only one row, a configuration known as a linear imaging array.

## Claims

1. A pixel sensor array structure disposed on a semiconductor substrate comprising:
a plurality of pixel sensors (150) arranged in an array;
a column line (152) for each column in said array, each said column line (152) coupled to the pixel sensors (150) associated with that column;
a plurality of load devices (158), each said load device (158) having a first terminal coupled to a corresponding one of said column lines (152), each said load device (158) coupled to a column reset line, said column reset line (160) operating to control each of said load devices (158) as a column reset switch;
a plurality of column select switches (162), each said column select switch (162) having a first terminal and a second terminal, said first terminal of each said column select switch (162) coupled to a corresponding one of said column lines (152); and
a common line (164), said common line (164) coupled to the second terminal of each of said column select switches (162) and to a buffer amplifier (166).

2. The pixel sensor array structure of claim 1, wherein each said load device (158) has a second terminal coupled to a first potential.

3. The pixel sensor array structure of claim 1, wherein each of said load devices (158) provides a bias current.

4. The pixel sensor array structure of claim 3, wherein each of said load devices (158) has on the order of at least one hundred times the area of a minimum device size of the technology to minimize random variations in their bias currents.

5. The pixel sensor array structure of claim 1, wherein each of said column select switches (162) is further coupled to a column decoder.

6. The pixel sensor array structure of claim 1, further including:
a unity-gain buffer amplifier (168) having an input and an output, said input coupled to said common line (164) and said output connected to a driven shield.

7. The pixel sensor array structure of claim 6, wherein said driven shield is provided on multiple layers of metal around the common line (164) to reduce the effective capacitance of the common line (164).

8. The pixel sensor array structure of claim 1, wherein said column select switches (162) are designed with an annular layout to minimize the capacitance they add to the common line (164).

9. The pixel sensor array structure of claim 1, further including a two-tap FIR filter coupled to said buffer amplifier (166).

10. The pixel sensor array structure of claim 1, wherein each of said pixel sensors (150) is a non-storage pixel sensor.

11. The pixel sensor array structure of claim 10, wherein each of said non-storage pixel sensors comprises:
a photodiode having a first terminal coupled to a first potential and a second terminal;
a semiconductor reset switch having a first terminal coupled to said second terminal of said photodiode and a second terminal connected to a reset potential that reverse biases said photodiode;
a semiconductor amplifier having an input connected to said second terminal of said photodiode and an output; and
a row select switch having first and second main terminals and a control terminal, said control terminal coupled to a row select line corresponding to the row in which the pixel sensor is located; said first main terminal coupled to said output of said semiconductor amplifier, and said second main terminal coupled to said column line corresponding to the column in which the pixel sensor is located.

12. The pixel sensor array structure of claim 1, wherein each of said pixel sensors (150) is a storage pixel sensor.

13. The pixel sensor array structure of claim 12, wherein each of sad storage pixel sensors comprises:
a capacitive storage element having a first terminal coupled to a fixed potential and a second terminal;
a photodiode having a first terminal coupled to a first potential and a second terminal;
a semiconductor reset switch having a first terminal coupled to said second terminal of said photodiode and a second terminal coupled to a reset potential that reverse biases said photodiode;
a semiconductor transfer switch having a first terminal coupled to said second terminal of said photodiode and a second terminal coupled to said second terminal of said capacitive storage element;
a semiconductor amplifier having an input connected to said second terminal of said capacitive storage element and an output; and
a row select switch having first and second main terminals and a control terminal, said control terminal coupled to a row select line corresponding to the row in which the pixel sensor is located, said first main terminal coupled to said output of said semiconductor amplifier, and said second main terminal coupled to said column line corresponding to the column in which the pixel sensor is located.

14. The pixel sensor array structure of claim 1, further including a unity-gain buffer amplifier (168) having an input and an output, said input coupled to said common line (164) and said output connected to a driven shield, and wherein each of said storage pixel sensors comprises:
a capacitive storage element having a first terminal coupled to a fixed potential and a second terminal;
a photodiode having a first terminal coupled to a first potential and a second terminal;
a semiconductor reset switch having a first terminal coupled to said second terminal of said photodiode and a second terminal coupled to a reset potential that reverse biases said photodiode;
a semiconductor transfer switch having a first terminal coupled to said second terminal of said photodiode and a second terminal coupled to said second terminal of said capacitive storage element;
a semiconductor amplifier having an input connected to said second terminal of said capacitive storage element and an output; and
a row select switch having first and second main terminals and a control terminal, said control terminal coupled to a row select line corresponding to the row in which the pixel sensor is located, said first main terminal coupled to said output of said semiconductor amplifier, and said second main terminal coupled to said column line corresponding to the column in which the pixel sensor is located.

15. The pixel sensor array structure of claim 14, wherein said semiconductor amplifier is a MOS transistor, and wherein said output of said semiconductor amplifier is the source terminal of said MOS transistor.

16. The pixel sensor array structure of claim 1, wherein rms fixed pattern noise due to random variations of the pixels is at least 10 times the rms fixed pattern striped noise.

17. The pixel sensor array structure of claim 1, further including a plurality of capacitors, each of said capacitors coupled to a corresponding one of said column lines (152) and each of said capacitors further coupled to a fixed potential.

18. The pixel sensor array structure of claim 1, wherein each said column select switch (162) coupled to a column decoder.

19. The pixel sensor array structure of claim 1, further include a unity-gain buffer amplifier (168) having an input and an output, said input coupled to said common line (164) and said output connected to a driven shield (170), said driven shield (170) provided on multiple layers of metal around the common line (164) to reduce the effective capacitance of the common line (164).

## Patentansprüche

1. Auf einem Halbleitersubstrat angeordnete Bildpunktsensor-Matrixstruktur, die Folgendes aufweist:
eine Vielzahl Bildpunktsensoren (150), die in einer Matrix angeordnet sind;
eine Spaltenleitung (152) für jede Spalte dieser Matrix, wobei jede dieser Spaltenleitungen (152) mit den zu der betreffenden Spalte gehörigen Bildpunktsensoren (150) gekoppelt ist;
eine Vielzahl Verbrauchergeräte (158), wobei jedes dieser Verbrauchergeräte (158) einen mit einer entsprechenden der Spaltenleitungen (152) gekoppelten ersten Anschluss hat, jedes dieser Verbrauchergeräte (158) mit einer Spaltenrückstellleitung gekoppelt ist, wobei die Spaltenrückstellleitung (160) zur Steuerung jedes der Verbrauchergeräte (158) als Spaltenrückstellschalter arbeitet;
eine Vielzahl Spaltenwahlschalter (162), wobei jeder dieser Spaltenwahlschalter (162) einen ersten Anschluss und einen zweiten Anschluss hat, wobei der erste Anschluss jedes dieser Spaltenwahlschalter (162) mit einer entsprechenden der Spaltenleitungen (152) gekoppelt ist; und
eine gemeinsame Leitung (164), wobei diese gemeinsame Leitung (164) mit dem zweiten Anschluss jedes dieser Spaltenwahlschalter (162) und mit einem Pufferverstärker (166) gekoppelt ist.

2. Bildpunktsensor-Matrixstruktur nach Anspruch 1, bei der jedes dieser Verbrauchergeräte (158) einen mit einem ersten Potenzial gekoppelten zweiten Anschluss hat.

3. Bildpunktsensor-Matrixstruktur nach Anspruch 1, bei der jedes dieser Verbrauchergeräte (158) einen Ruhestrom bereitstellt.

4. Bildpunktsensor-Matrixstruktur nach Anspruch 1, bei der jedes dieser Verbrauchergeräte (158) eine Fläche in der Größenordnung von mindestens dem Hundertfachen der Fläche einer in der Technologie üblichen Mindestgerätegröße hat, um regellose Schwankungen ihrer Ruheströme zu minimieren.

5. Bildpunktsensor-Matrixstruktur nach Anspruch 1, bei der jeder dieser Spaltenwahlschalter (162) des Weiteren mit einem Spaltendecodierer gekoppelt ist.

6. Bildpunktsensor-Matrixstruktur nach Anspruch 1, die des Weiteren enthält:
einen Pufferverstärker (168) mit Verstärkungsfaktor eins mit einem Eingang und einem Ausgang, wobei der Eingang mit der gemeinsamen Leitung (164) gekoppelt und der Ausgang mit einer passiven Abschirmung verbunden ist.

7. Bildpunktsensor-Matrixstruktur nach Anspruch 6, bei der die passive Abschirmung auf mehreren Lagen aus Metall um die gemeinsame Leitung (164) vorgesehen ist, um die effektive Kapazität der gemeinsamen Leitung (164) zu verringern.

8. Bildpunktsensor-Matrixstruktur nach Anspruch 1, bei der die Spaltenwahlschalter (162) in einer ringförmigen Auslegung konzipiert sind, um die Kapazität auf ein Mindestmaß zu senken, die sie zur gemeinsamen Leitung (164) hinzufügen.

9. Bildpunktsensor-Matrixstruktur nach Anspruch 1, die des Weiteren ein mit dem Pufferverstärker (166) gekoppeltes FIR-Filter mit zwei Abgriffen enthält.

10. Bildpunktsensor-Matrixstruktur nach Anspruch 1, bei der jeder dieser Bildpunktsensoren (150) ein nicht speichernder Bildpunktsensor ist.

11. Bildpunktsensor-Matrixstruktur nach Anspruch 10, bei der jeder dieser nicht speichernden Bildpunktsensoren Folgendes aufweist:
eine Photodiode mit einem mit einem ersten Potenzial gekoppelten ersten Anschluss und einem zweiten Anschluss;
einen Halbleiter-Rückstellschalter mit einem mit dem zweiten Anschluss der Photodiode gekoppelten ersten Anschluss und
einem mit einem Rückstellpotenzial, das die Photodiode umgekehrt vorspannt, verbundenen zweiten Anschluss;
einen Halbleiterverstärker mit einem mit dem zweiten Anschluss der Photodiode verbundenen Eingang und einem Ausgang; und
einen Zeilenwahlschalter mit ersten und zweiten Hauptanschlüssen und einem Steueranschluss, wobei der Steueranschluss mit einer Zeilenwahlleitung entsprechend der Zeile, in der sich der Bildpunktsensor befindet, gekoppelt ist, der erste Hauptanschluss mit dem Ausgang des Halbleiterverstärkers gekoppelt ist und der zweite Hauptanschluss mit der Spaltenleitung entsprechend der Spalte, in der sich der Bildpunktsensor befindet, gekoppelt ist.

12. Bildpunktsensor-Matrixstruktur nach Anspruch nach Anspruch 1, bei der jeder dieser Bildpunktsensoren (150) ein speichernder Bildpunktsensor ist.

13. Bildpunktsensor-Matrixstruktur nach Anspruch 12, bei jeder dieser speichernden Bildpunktsensoren Folgendes aufweist:
ein kapazitives Speicherelement mit einem mit einem fixierten Potenzial gekoppelten ersten Anschluss und einem zweiten Anschluss;
eine Photodiode mit einem mit einem ersten Potenzial gekoppelten ersten Anschluss und einem zweiten Anschluss;
einen Halbleiter-Rückstellschalter mit einem mit dem zweiten Anschluss der Photodiode gekoppelten ersten Anschluss und
einem mit einem Rückstellpotenzial, das die Photodiode umgekehrt vorspannt, gekoppelten zweiten Anschluss;
einen Halbleiterumschalter mit einem mit dem zweiten Anschluss der Photodiode gekoppelten ersten Anschluss und einem mit dem zweiten Anschluss des kapazitiven Speicherelements gekoppelten zweiten Anschluss;
einen Halbleiterverstärker mit einem mit dem zweiten Anschluss des kapazitiven Speicherelements verbundenen Eingang und einem Ausgang; und
einen Zeilenwahlschalter mit ersten und zweiten Hauptanschlüssen und einem Steueranschluss, wobei der Steueranschluss mit einer Zeilenwahlleitung entsprechend der Zeile, in der sich der Bildpunktsensor befindet, gekoppelt ist, der erste Hauptanschluss mit dem Ausgang des Halbleiterverstärkers gekoppelt ist und der zweite Hauptanschluss mit der Spaltenleitung entsprechend der Spalte, in der sich der Bildpunktsensor befindet, gekoppelt ist.

14. Bildpunktsensor-Matrixstruktur nach Anspruch 1, die des Weiteren einen Pufferverstärker (168) mit Verstärkungsfaktor eins enthält, der einen Eingang und einen Ausgang hat, wobei der Eingang mit der gemeinsamen Leitung (164) gekoppelt ist und der Ausgang mit einer passiven Abschirmung gekoppelt ist, und bei der jeder der Bildpunktsensoren Folgendes aufweist:
ein kapazitives Speicherelement mit einem mit einem fixierten Potenzial gekoppelten ersten Anschluss und einem zweiten Anschluss;
eine Photodiode mit einem mit einem ersten Potenzial gekoppelten ersten Anschluss und einem zweiten Anschluss;
einen Halbleiter-Rückstellschalter mit einem mit dem zweiten Anschluss der Photodiode gekoppelten ersten Anschluss und
einem mit einem Rückstellpotenzial, das die Photodiode umgekehrt vorspannt, gekoppelten zweiten Anschluss;
einen Halbleiterumschalter mit einem mit dem zweiten Anschluss der Photodiode gekoppelten ersten Anschluss und einem mit dem zweiten Anschluss des kapazitiven Speicherelements gekoppelten zweiten Anschluss;
einen Halbleiterverstärker mit einem mit dem zweiten Anschluss des kapazitiven Speicherelements verbundenen Eingang und einem Ausgang; und
einen Zeilenwahlschalter mit ersten und zweiten Hauptanschlüssen und einem Steueranschluss, wobei der Steueranschluss mit einer Zeilenwahlleitung entsprechend der Zeile, in der sich der Bildpunktsensor befindet, gekoppelt ist, der erste Hauptanschluss mit dem Ausgang des Halbleiterverstärkers gekoppelt ist und der zweite Hauptanschluss mit der Spaltenleitung entsprechend der Spalte, in der sich der Bildpunktsensor befindet, gekoppelt ist.

15. Bildpunktsensor-Matrixstruktur nach Anspruch 14, bei der der Halbleiterverstärker ein MOS-Transistor ist und bei der der Ausgang des Halbleiterverstärkers der Source-Anschluss des MOS-Transistors ist.

16. Bildpunktsensor-Matrixstruktur nach Anspruch 1, bei der der Effektivwert der fixierten Strukturstörungen aufgrund von statistischen Schwankungen der Bildpunkte mindestens dem Zehnfachen des Effektivwertes der streifenförmigen Störungen mit fixierter Struktur entspricht.

17. Bildpunktsensor-Matrixstruktur nach Anspruch 1, die des Weiteren eine Vielzahl Kondensatoren enthält, wobei jeder dieser Kondensatoren mit einer entsprechenden der Spaltenleitungen (152) und jeder dieser Kondensatoren des Weiteren mit einem fixierten Potenzial gekoppelt ist.

18. Bildpunktsensor-Matrixstruktur nach Anspruch 1, bei der jeder Spaltenwahlschalter (162) mit einem Spaltendecodierer gekoppelt ist.

19. Bildpunktsensor-Matrixstruktur nach Anspruch 1, die des Weiteren einen Pufferverstärker (168) mit Verstärkungsfaktor eins mit einem Eingang und einem Ausgang enthält, wobei der Eingang mit der gemeinsamen Leitung (164) gekoppelt und der Ausgang mit einer passiven Abschirmung (170) verbunden ist, wobei die passive Abschirmung (170) auf mehreren Lagen aus Metall um die gemeinsame Leitung (164) vorgesehen ist, um die effektive Kapazität der gemeinsamen Leitung (164) zu verringern.

## Revendications

1. Structure de réseau de capteurs de pixel disposée sur un substrat semiconducteur, comprenant :
une pluralité de capteurs de pixel (150) qui sont agencés selon un réseau ;
une ligne de colonne (152) pour chaque colonne dans ledit réseau, chaque dite ligne de colonne (152) étant couplée aux capteurs de pixel (150) qui sont associés à cette colonne ;
une pluralité de dispositifs de charge (158), chaque dit dispositif de charge (158) comportant une première borne qui est couplée à l'une correspondante desdites lignes de colonne (152), chaque dit dispositif de charge (158) étant couplé à une ligne de remise à l'état initial de colonne, ladite ligne de remise à l'état initial de colonne (160) fonctionnant pour commander chacun desdits dispositifs de charge (158) en tant que commutateur de remise à l'état initial de colonne ;
une pluralité de commutateurs de sélection de colonne (162), chaque dit commutateur de sélection de colonne (162) comportant une première borne et une seconde borne, ladite première borne de chaque dit commutateur de sélection de colonne (162) étant couplée à l'une correspondante desdites lignes de colonne (152) ; et
une ligne commune (164), ladite ligne commune (164) étant couplée à la seconde borne de chacun desdits commutateurs de sélection de colonne (162) ainsi qu'à un amplificateur tampon (166).

2. Structure de réseau de capteurs de pixel selon la revendication 1, dans laquelle chaque dit dispositif de charge (158) comporte une second borne qui est couplée à un premier potentiel.

3. Structure de réseau de capteurs de pixel selon la revendication 1, dans laquelle chacun desdits dispositifs de charge (158) applique un courant de polarisation.

4. Structure de réseau de capteurs de pixel selon la revendication 3, dans laquelle chacun desdits dispositifs de charge (158) présente une aire de l'ordre d'au moins 100 fois l'aire d'une dimension de dispositif minimum de la technologie afin de minimiser des variations aléatoires au niveau des courants de polarisation afférents.

5. Structure de réseau de capteurs de pixel selon la revendication 1, dans laquelle chacun desdits commutateurs de sélection de colonne (162) est en outre couplé à un décodeur de colonne.

6. Structure de réseau de capteurs de pixel selon la revendication 1, incluant en outre :
un amplificateur tampon de gain unitaire (168) qui comporte une entrée et une sortie, ladite entrée étant couplée à ladite ligne commune (164) et ladite sortie étant connectée à un blindage piloté.

7. Structure de réseau de capteurs de pixel selon la revendication 6, dans laquelle ledit blindage piloté est prévu sur de multiples couches de métal autour de la ligne commune (164) afin de réduire la valeur de capacité efficace de la ligne commune (164).

8. Structure de réseau de capteurs de pixel selon la revendication 1, dans laquelle lesdits commutateurs de sélection de colonne (162) sont conçus moyennant une implantation annulaire afin de minimiser la valeur de capacité qu'ils additionnent à la ligne commune (164).

9. Structure de réseau de capteurs de pixel selon la revendication 1, incluant en outre un filtre FIR à deux connexions intermédiaires qui est couplé audit amplificateur tampon (166).

10. Structure de réseau de capteurs de pixel selon la revendication 1, dans laquelle chacun desdits capteurs de pixel (150) est un capteur de pixel de non stockage.

11. Structure de réseau de capteurs de pixel selon la revendication 10, dans laquelle chacun desdits capteurs de pixel de non stockage comprend :
une photodiode qui comporte une première borne qui est couplée à un premier potentiel et une seconde borne ;
un commutateur de remise à l'état initial à semiconducteur qui comporte une première borne qui est couplée à ladite seconde borne de ladite photodiode et une seconde borne qui est connectée à un potentiel de remise à l'état initial qui polarise de façon inverse ladite photodiode ;
un amplificateur à semiconducteur qui comporte une entrée qui est connectée à ladite seconde borne de ladite photodiode et une sortie ; et
un commutateur de sélection de rangée qui comporte des première et seconde bornes principales et une borne de commande, ladite borne de commande étant couplée à une ligne de sélection de rangée qui correspond à la rangée dans laquelle le capteur de pixel est localisé,
ladite première borne principale étant couplée à ladite sortie dudit amplificateur à semiconducteur et ladite seconde borne principale étant couplée à ladite ligne de colonne qui correspond à la colonne dans laquelle le capteur de pixel est localisé.

12. Structure de réseau de capteurs de pixel selon la revendication 1, dans laquelle chacun desdits capteurs de pixel (150) est un capteur de pixel de stockage.

13. Structure de réseau de capteurs de pixel selon la revendication 12, dans laquelle chacun desdits capteurs de pixel de stockage comprend :
un élément de stockage capacitif qui comporte une première borne qui est couplée à un potentiel fixe et une seconde borne ;
une photodiode qui comporte une première borne qui est couplée à un premier potentiel et une seconde borne ;
un commutateur de remise à l'état initial à semiconducteur qui comporte une première borne qui est couplée à ladite seconde borne de ladite photodiode et une seconde borne qui est couplée à un potentiel de remise à l'état initial qui polarise de façon inverse ladite photodiode ;
un commutateur de transfert à semiconducteur qui comporte une première borne qui est couplée à ladite seconde borne de ladite photodiode et une seconde borne qui est couplée à ladite seconde borne dudit élément de stockage capacitif ;
un amplificateur à semiconducteur qui comporte une entrée qui est connectée à ladite seconde borne dudit élément de stockage capacitif et une sortie ; et
un commutateur de sélection de rangée qui comporte des première et seconde homes principales et une borne de commande, ladite borne de commande étant couplée à une ligne de sélection de rangée qui correspond à la rangée dans laquelle le capteur de pixel est localisé, ladite première borne principale étant couplée à ladite sortie dudit amplificateur à semiconducteur et ladite seconde borne principale étant couplée à ladite ligne de colonne qui correspond à la colonne dans laquelle le capteur de pixel est localisé.

14. Structure de réseau de capteurs de pixel selon la revendication 1, incluant en outre un amplificateur tampon à gain unitaire (168) qui comporte une entrée et une sortie, ladite entrée étant couplée à ladite ligne commune (164) et ladite sortie étant connectée à un blindage piloté et dans laquelle chacun desdits capteurs de pixel de stockage comprend :
un élément de stockage capacitif qui comporte une première borne qui est couplée à un potentiel fixe et une seconde borne ;
une photodiode qui comporte une première borne qui est couplée à un premier potentiel et une seconde borne ;
un commutateur de remise à l'état initial à semiconducteur qui comporte une première borne qui est couplée à ladite seconde borne de ladite photodiode et une seconde borne qui est couplée à un potentiel de remise à l'état initial qui polarise de façon inverse ladite photodiode ;
un commutateur de transfert à semiconducteur qui comporte une première borne qui est couplée à ladite seconde borne de ladite photodiode et une seconde borne qui est couplée à ladite seconde borne dudit élément de stockage capacitif ;
un amplificateur à semiconducteur qui comporte une entrée qui est connectée à ladite seconde borne dudit élément de stockage capacitif et une sortie ; et
un commutateur de sélection de rangée qui comporte des première et seconde bornes principales et une borne de commande, ladite borne de commande étant couplée à une ligne de sélection de rangée qui correspond à la rangée dans laquelle le capteur de pixel est localisé, ladite première borne principale étant couplée à ladite sortie dudit amplificateur à semiconducteur et ladite seconde borne principale étant couplée à ladite ligne de colonne qui correspond à la colonne dans laquelle le capteur de pixel est localisé.

15. Structure de réseau de capteurs de pixel selon la revendication 14, dans laquelle ledit amplificateur à semiconducteur est un transistor MOS et dans laquelle ladite sortie dudit amplificateur à semiconducteur est la borne de source dudit transistor MOS.

16. Structure de réseau de capteurs de pixel selon la revendication 1, dans laquelle un bruit de motif fixe quadratique qui est dû à des variations aléatoires des pixels est égal à au moins 10 fois le bruit en bande de motif fixe quadratique.

17. Structure de réseau de capteurs de pixel selon la revendication 1, incluant en outre une pluralité de condensateurs, chacun desdits condensateurs étant couplé à l'une correspondante desdites lignes de colonne (152) et chacun desdits condensateurs étant en outre couplé à un potentiel fixe.

18. Structure de réseau de capteurs de pixel selon la revendication 1, dans laquelle chaque dit commutateur de sélection de colonne (162) est couplé à un décodeur de colonne.

19. Structure de réseau de capteurs de pixel selon la revendication 1, incluant en outre un amplificateur tampon à gain unitaire (168) qui comprend une entrée et une sortie, ladite entrée étant couplée à ladite ligne commune (164) et ladite sortie étant connectée à un blindage piloté (170), ledit blindage piloté (170) étant prévu sur de multiples couches de métal autour de la ligne commune (164) afin de réduire la valeur de capacité efficace de la ligne commune (164).
